# EUROPEAN PATENT APPLICATION

(11) **EP 4 653 895 A1**
(43) Date of publication of application: **26.11.2025**
(21) Application number: 24845915.8
(22) Date of filing: 17.07.2024
(51) Int. Cl.: G01R 31/392, G01R 31/52, G01R 31/56, G01R 31/385, G01R 19/10, G01R 19/12, G01R 19/165, H01M 10/0525

(54) **APPARATUS AND METHOD FOR DIAGNOSING BATTERY**

(30) Priority: 27.07.2023 KR 20230098509
(71) Applicant: LG Energy Solution, Ltd., Seoul 07335 (KR)
(72) Inventor: SONG, Yee-Gahng, Daejeon 34122 (KR); KIM, Ki-Hoon, Daejeon 34122 (KR)
(74) Representative: Goddar, Heinz J.
(86) International application number: PCT/KR2024/010311
(87) International publication number: WO 2025/023613

(57) **Abstract**

An apparatus for diagnosing a battery according to an embodiment of the present disclosure includes a voltage measuring unit configured to measure voltages of a plurality of batteries; and a control unit configured to calculate a voltage deviation of the plurality of batteries according to the measured plurality of voltages, calculate a voltage deviation change amount of each of the plurality of batteries based on the calculated voltage deviation, compare the voltage deviation change amount of each of the plurality of batteries with a preset reference change amount, and diagnose a state of each of the plurality of batteries according to the comparison result.

## Description

### TECHNICAL FIELD

The present application claims priority to Korean Patent Application No. 10-2023-0098509 filed on July 27, 2023, in the Republic of Korea, the disclosures of which are incorporated herein by reference.

The present disclosure relates to an apparatus and method for diagnosing a battery, and more particularly, to an apparatus and method for diagnosing a battery, which may diagnose an internal micro short circuit of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

If a micro short circuit occurs inside a battery, there is a problem that leakage current occurs in the battery. For example, it is assumed that a plurality of batteries are included in a battery pack. If an internal micro short circuit occurs in one battery and leakage current occurs, the voltage of the corresponding battery may gradually decrease compared to the voltages of other batteries. In addition, if this phenomenon continues, a hard short circuit may occur, which may cause permanent damage to the battery pack.

Therefore, it is necessary to develop a technology that may diagnose in advance whether a micro short circuit occurs inside the battery.

### DISCLOSURE

### Technical Problem

The present disclosure is designed to solve the problems of the related art, and therefore the present disclosure is directed to providing an apparatus and method for diagnosing a battery, which diagnoses whether an internal micro short circuit occurs in a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a voltage measuring unit configured to measure voltages of a plurality of batteries; and a control unit configured to calculate a voltage deviation of the plurality of batteries according to the measured plurality of voltages, calculate a voltage deviation change amount of each of the plurality of batteries based on the calculated voltage deviation, compare the voltage deviation change amount of each of the plurality of batteries with a preset reference change amount, and diagnose a state of each of the plurality of batteries according to the comparison result.

The control unit may be configured to calculate the voltage deviation change amount of each of the plurality of batteries based on a difference between the voltage deviation calculated at a current time point and a previous voltage deviation calculated at a previous time point.

The control unit may be configured to calculate the voltage deviation change amount by normalizing the difference between the voltage deviation and the previous voltage deviation with respect to a difference between the current time point and the previous time point.

The control unit may be configured to calculate a difference in voltage deviation by calculating the difference between the voltage deviation and the previous voltage deviation, calculate a difference in time point by calculating the difference between the current time point and the previous time point, and calculate the voltage deviation change amount for a unit time point by dividing the difference in voltage deviation by the difference in time point.

The control unit may be configured to diagnose a state of a battery in which the voltage deviation change amount is greater than or equal to the reference change amount as an abnormal state.

The control unit may be configured to diagnose a state of a battery in which the voltage deviation change amount is less than the reference change amount as a normal state.

The control unit may be configured to calculate the number of times the voltage deviation change amount is greater than or equal to the reference change amount and to diagnose a state of a battery in which the calculated number reaches a preset reference number as an abnormal state.

The control unit may be configured to diagnose that an internal micro short circuit occurs in the battery diagnosed as being in the abnormal state.

A battery pack according to another aspect of the present disclosure may comprise the apparatus for diagnosing a battery according to one aspect of the present disclosure.

A vehicle according to still another aspect of the present disclosure may comprise the apparatus for diagnosing a battery according to one aspect of the present disclosure.

A method for diagnosing a battery according to still another aspect of the present disclosure may comprise: a voltage measuring step of measuring voltages of a plurality of batteries; a voltage deviation calculating step of calculating a voltage deviation of the plurality of batteries according to the plurality of voltages measured in the voltage measuring step; a voltage deviation change amount calculating step of calculating a voltage deviation change amount of each of the plurality of batteries based on the voltage deviation calculated in the voltage deviation calculating step; a comparing step of comparing the voltage deviation change amount of each of the plurality of batteries with a preset reference change amount; and a diagnosing step of diagnosing a state of each of the plurality of batteries according to the comparison result of the comparing step.

### Advantageous Effects

According to one aspect of the present disclosure, the apparatus for diagnosing a battery may diagnose the state of each of a plurality of batteries by tracking the trend of a voltage deviation change amount of the battery. Specifically, the apparatus for diagnosing a battery may quickly diagnose whether an internal micro short circuit occurs in each of a plurality of batteries.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to the present disclosure.
FIG. 2 is a schematic diagram showing voltages for a plurality of battery cells according to an embodiment of the present disclosure.
FIG. 3 is a schematic diagram showing a voltage deviation change amount according to an embodiment of the present disclosure.
FIG. 4 is a schematic diagram showing a diagnostic embodiment according to an embodiment of the present disclosure.
FIG. 5 is a diagram showing an exemplary configuration of a battery pack according to another embodiment of the present disclosure.
FIG. 6 is a diagram schematically showing a vehicle according to still another embodiment of the present disclosure.
FIG. 7 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

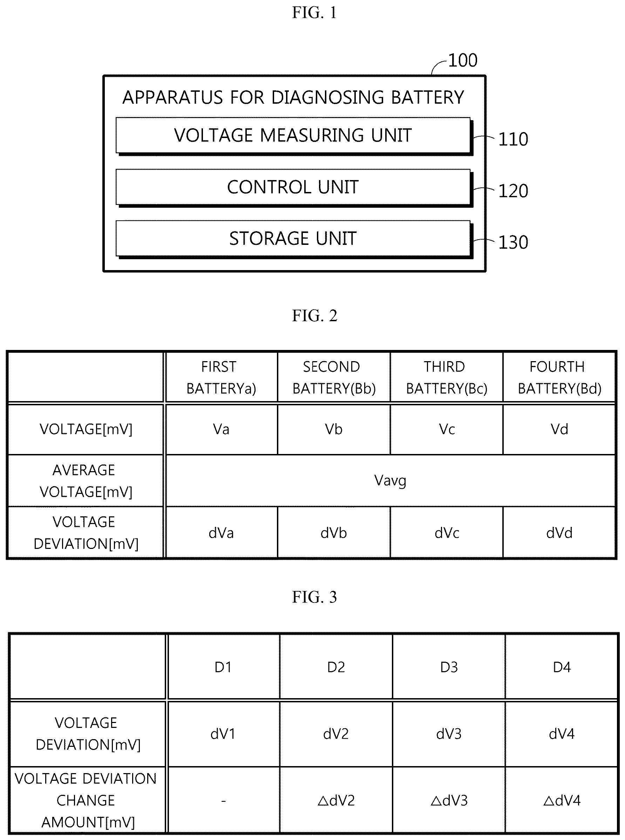

FIG. 1 is a diagram schematically illustrating an apparatus 100 for diagnosing a battery according to an embodiment of the present disclosure.

Referring to FIG. 1, the apparatus 100 for diagnosing a battery may include a voltage measuring unit 110 and a control unit 120.

Here, the battery refers to an independent cell that has a negative electrode terminal and a positive electrode terminal and is physically separable. As an example, a lithium-ion cell or a lithium polymer cell may be considered a battery. Also, the battery may also mean a battery module having a plurality of cells connected in series and/or in parallel. Below, for convenience of explanation, a battery is described as meaning a single independent cell.

The voltage measuring unit 110 may be configured to measure the voltages of a plurality of batteries.

Specifically, the voltage measuring unit 110 may be configured to measure the voltage of each of the plurality of batteries. Preferably, the voltage measuring unit 110 may measure the open circuit voltage (OCV) of each of the plurality of batteries. For example, the voltage measuring unit 110 may measure the open circuit voltage of the plurality of batteries when charging or discharging of the plurality of batteries is completed and a rest time has elapsed.

FIG. 2 is a schematic diagram showing voltages for a plurality of battery cells according to an embodiment of the present disclosure.

In the embodiment of FIG. 2, it is assumed that a first battery Ba, a second battery Bb, a third battery Bc, and a fourth battery Bd are provided. The voltage measuring unit 110 may measure the voltage of the first battery Ba as Va, the voltage of the second battery Bb as Vb, the voltage of the third battery Bc as Vc, and the voltage of the fourth battery Bd as Vd.

In addition, the voltage measuring unit 110 may be connected to communicate with the control unit 120. For example, the voltage measuring unit 110 and the control unit 120 may be connected by wire and/or wirelessly. The voltage measuring unit 110 may transmit information about the measured voltage to the control unit 120.

The control unit 120 may be configured to calculate a voltage deviation of the plurality of batteries based on the measured plurality of voltages.

Specifically, the control unit 120 may receive voltage information of a plurality of batteries from the voltage measuring unit 110 and calculate a voltage deviation of the plurality of batteries based on the received voltage information.

First, the control unit 120 may be configured to calculate an average voltage of the plurality of batteries. In the embodiment of FIG. 2, the control unit 120 may calculate an average voltage for voltages of the first to fourth batteries Ba, Bb, Bc, Bd. For example, the control unit 120 may calculate the average voltage as Vavg by calculating the formula of "(Va + Vb + Vc + Vd) ÷ 4".

Next, the control unit 120 may be configured to calculate the difference between the calculated average voltage and the voltage of each of the plurality of batteries to calculate the voltage deviation of each of the plurality of batteries. In the embodiment of FIG. 2, the control unit 120 may calculate the difference between the voltage of the first to fourth batteries Ba, Bb, Bc, Bd and the average voltage to calculate the voltage deviation of the first to fourth batteries Ba, Bb, Bc, Bd. For example, the control unit 120 may calculate the voltage deviation of the first battery Ba as dVa by calculating the formula "|Va - Vavg|", and may calculate the voltage deviation of the second battery Bb as dVb by calculating the formula "|Vb - Vavg|". Also, the control unit 120 may calculate the voltage deviation of the third battery Bc as dVc by calculating the formula of "|Vc - Vavg|", and may calculate the voltage deviation of the fourth battery Bd as dVd by calculating the formula of "|Vd - Vavg|". Here, "∥" is an absolute value symbol, and the calculated voltage deviation may be expressed as the absolute value of the difference between the voltage of the battery and the average voltage.

The control unit 120 may be configured to calculate a voltage deviation change amount for each of the plurality of batteries based on the calculated voltage deviation.

Specifically, the control unit 120 may be configured to calculate the voltage deviation change amount of each of the plurality of batteries based on the difference between the voltage deviation calculated at the current time point and the previous voltage deviation calculated at the previous time point. For example, the control unit 120 may calculate the voltage deviation and voltage deviation change amount of each of the plurality of batteries whenever the voltage of the plurality of batteries is measured by the measuring unit 110. Here, when the voltage deviation of the plurality of batteries is calculated for the first time, the voltage deviation calculated at the previous time point does not exist, so calculation of the voltage deviation change amount may be omitted.

FIG. 3 is a schematic diagram showing a voltage deviation change amount according to an embodiment of the present disclosure. Specifically, the embodiment of FIG. 3 is a diagram showing only the voltage deviation of the first battery Ba among the voltage deviations of the first to fourth batteries Ba, Bb, Bc, Bd calculated at time points D1, D2, D3, and D4.

For example, in the embodiment of FIG. 3, D1, D2, D3, and D4 represent time points at which the voltage of the first battery Ba is measured. Specifically, D1, D2, D3, and D4 represent days at which the voltage of the first battery Ba is measured. Here, the intervals of D1, D2, D3, and D4 may be the same or different. That is, it should be noted that the intervals of D1, D2, D3, and D4 are not limited to a predetermined cycle.

Meanwhile, although FIG. 3 only shows the voltage deviation of the first battery Ba, it should be noted that the voltage deviations of the second to fourth batteries Bb, Bc, Bd are also calculated for the state diagnosis of the second to fourth batteries Bb, Bc, Bd.

In the embodiment of FIG. 3, the first voltage deviation of the first battery Ba calculated at the D1 time point is dV1, the second voltage deviation of the first battery Ba calculated at the D2 time point is dV2, the third voltage deviation of the first battery Ba calculated at the D3 time point is dV3, and the fourth voltage deviation of the first battery Ba calculated at the D4 time point is dV4. The control unit 120 may calculate the difference of the voltage deviations at consecutive time points to calculate the voltage deviation change amount for the first battery Ba. The control unit 120 may calculate the difference between the voltage deviations of the D1 time point and the D2 time point according to the formula of "dV2 - dV1" to calculate the second voltage deviation change amount corresponding to the D2 time point as △dV2. The control unit 120 may calculate the difference between the voltage deviations of the D2 time point and the D3 time point according to the formula of "dV3 - dV2" to calculate the third voltage deviation change amount corresponding to the D3 time point as △dV3. The control unit 120 may calculate the difference between the voltage deviations of the D4 time point and the D3 time point according to the formula of "dV4 - dV3" to calculate the fourth voltage deviation change amount corresponding to the D4 time point as △dV4.

The control unit 120 may be configured to compare the voltage deviation change amount of each of the plurality of batteries with a preset reference change amount. In addition, the control unit 120 may be configured to diagnose a state of each of the plurality of batteries based on the comparison result.

Here, the reference change amount may be set in consideration of the characteristics of the battery. Specifically, the reference change amount may be set in consideration of the shape of the battery (cylindrical, pouch-shaped, square, etc.), internal materials (positive electrode material, negative electrode material, separator, electrolyte, etc.), and specifications. For example, the reference change amount may be set based on the voltage deviation change amount when an internal micro short circuit occurs in a reference battery (set to correspond to a battery to be diagnosed).

The control unit 120 may compare the magnitude of the voltage deviation change amount of each of the plurality of batteries with the reference change amount. For example, in the embodiment of FIG. 3, the control unit 120 may diagnose the state of the battery at time point D2 by comparing the second voltage deviation change amount (△dV2) at time point D2 with the reference change amount. The control unit 120 may diagnose the state of the battery at time point D3 by comparing the third voltage deviation change amount (△dV3) at time point D3 with the reference change amount. The control unit 120 may diagnose the state of the battery at time point D4 by comparing the fourth voltage deviation change amount (△dV4) at time point D4 with the reference change amount.

In addition, the control unit 120 may be configured to diagnose the state of the battery in which the voltage deviation change amount is greater than or equal to the reference change amount as an abnormal state. Conversely, the control unit 120 may be configured to diagnose the state of the battery in which the voltage deviation change amount is less than the reference change amount as a normal state.

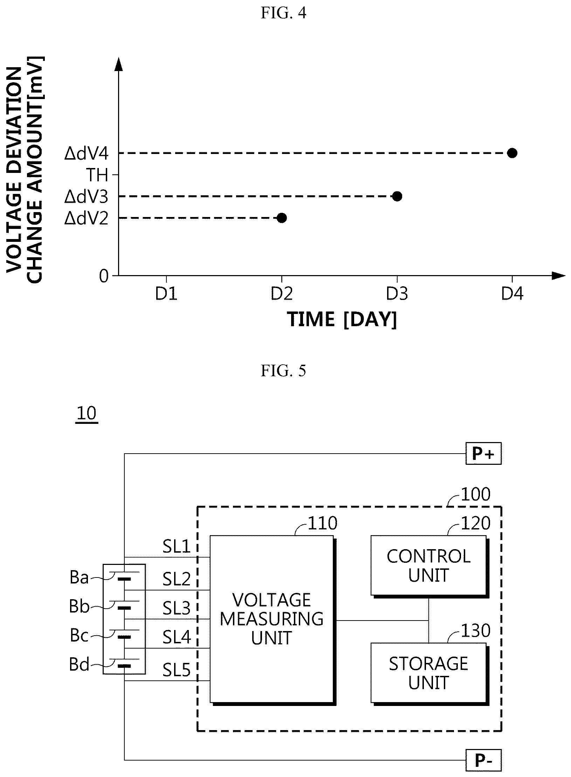

FIG. 4 is a schematic diagram showing a diagnostic embodiment according to an embodiment of the present disclosure. Specifically, the embodiment of FIG. 4 is an embodiment in which the voltage deviation change amount (△dV2, △dV3, △dV4) of the first battery according to the embodiment of FIG. 3 is compared with the reference change amount (TH).

For example, in the embodiment of FIG. 4, since the second voltage deviation change amount (△dV2) and the third voltage deviation change amount (△dV3) are smaller than the reference change amount (TH), the control unit 120 may diagnose the state of the battery as a normal state at the D2 time point and the D3 time point. Since the fourth voltage deviation change amount (△dV4) is larger than the reference change amount (TH), the control unit 120 may diagnose the state of the battery as an abnormal state at the D4 time point.

The apparatus 100 for diagnosing a battery according to an embodiment of the present disclosure has an advantage in that it may immediately diagnose the state of a battery by considering the voltage deviation change amount compared with that of the previous time point at each diagnosis time point. In other words, the apparatus 100 for diagnosing a battery has an advantage in that it may quickly diagnose the state of a battery even without considering the long-term trend of the change in the state of the battery.

In addition, the apparatus 100 for diagnosing a battery primarily determines the relative voltage behavior (voltage deviation) of a plurality of batteries, and secondarily determines the change in the relative voltage behavior (voltage deviation change amount) over time for each battery. That is, since the apparatus 100 for diagnosing a battery diagnoses the state of a plurality of batteries by considering both the relative voltage behavior of a plurality of batteries and the change in the voltage behavior of each battery, it has the advantage of being able to more accurately diagnose the state of a plurality of batteries.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

The control unit 120 may be configured to calculate the voltage deviation change amount by normalizing the difference between the voltage deviation and the previous voltage deviation with respect to the difference between the current time point and the previous time point.

Specifically, the control unit 120 may diagnose the state of the plurality of batteries based on the time point at which the measuring unit 110 measures the voltage of the plurality of batteries. Here, if the measuring unit 110 measures the voltage non-periodically, the difference between the previous time point and the current time point may not be constant. In addition, if the measuring unit 110 measures the voltage periodically but the measurement cycle is too long, the voltage deviation change amount of each of the plurality of batteries cannot help but increase. Therefore, the control unit 120 may diagnose the state of the plurality of batteries more accurately by calculating the voltage deviation change amount for each unit time point for each of the plurality of batteries.

The control unit 120 may be configured to calculate the difference of the voltage deviation by calculating the difference between the voltage deviation and the previous voltage deviation. For example, in the embodiment of FIG. 3, the control unit 120 may calculate the second voltage deviation change amount (△dV2) by calculating the difference between the first voltage deviation (dV1) and the second voltage deviation (dV2) at time point D2.

The control unit 120 may be configured to calculate the difference of time points by calculating the difference between the current time point and the previous time point. For example, in the embodiment of FIG. 3, the control unit 120 may calculate the difference of time points (dD12) between the time point D2 and the time point D1.

The control unit 120 may be configured to calculate the voltage deviation change amount for the unit time point by dividing the difference in voltage deviation by the difference in time point. For example, in the embodiment of FIG. 3, the control unit 120 may calculate the second voltage deviation change amount for the unit time point by calculating the equation "second voltage deviation change amount (△dV2) ÷ difference in time point (D2 - D1)". The control unit 120 may calculate the third voltage deviation change amount for the unit time point by calculating the equation "third voltage deviation change amount (△dV3) ÷ difference in time point (D3 - D2)". The control unit 120 may calculate the fourth voltage deviation change amount for the unit time point by calculating the equation "fourth voltage deviation change amount (△dV4) ÷ difference in time point (D4 - D3)". If the time points D1, D2, D3 and D4 are time points for a day, the control unit 120 may calculate the daily voltage deviation change amount.

Since the apparatus 100 for diagnosing a battery diagnoses the state of the battery based on the voltage deviation change amount for a unit time point, the possibility of misdiagnosis of the battery state due to the time point difference between the previous time point and the current time point may be reduced.

The control unit 120 may be configured to calculate the number of times the voltage deviation change amount is greater than or equal to the reference change amount. In addition, the control unit 120 may be configured to diagnose the state of the battery when the calculated number of times reaches a preset reference number as an abnormal state.

Here, the reference number is set to prevent the state of the battery from being diagnosed incorrectly. For example, the reference number may be set to 3 times. In this case, the control unit 120 may diagnose the state of the battery as an abnormal state when the number of times the voltage deviation change amount is greater than or equal to the reference change amount reaches 3 times.

For example, the voltage of a plurality of batteries may be inaccurate due to measurement noise, etc. If the state of the battery is diagnosed based on the inaccurate voltage, there is a concern that the state of the battery may be incorrectly diagnosed. Therefore, the apparatus 100 for diagnosing a battery may diagnose the state of the battery by further considering the number of times that the voltage deviation change amount is greater than or equal to the reference change amount in order to prevent the state of the battery from being incorrectly diagnosed due to unexpected noise, etc.

The control unit 120 may be configured to diagnose that an internal micro short circuit occurs in a battery diagnosed as being in an abnormal state.

In general, the occurrence of an internal micro short circuit may be judged by observing the voltage behavior of the battery for a long period of time. That is, the state of the battery is diagnosed by considering the long-term trend of the battery voltage. This is because an internal micro short circuit is difficult to immediately confirm through the voltage behavior of a single battery. However, an internal micro short circuit worsens as the battery is used, and the worsened internal short circuit may cause performance degradation and damage to the battery.

The apparatus 100 for diagnosing a battery has an advantage in that it may quickly diagnose the state of a battery without checking the long-term voltage behavior of each battery by considering the voltage deviation between a plurality of batteries and the voltage deviation change amount of each battery. In other words, the apparatus 100 for diagnosing a battery has an advantage in that it may prevent problems such as performance degradation or hard short in a battery from occurring in an unexpected situation by quickly diagnosing the state of a battery.

In one embodiment, the control unit 120 may cut off the electrical connection between a battery diagnosed as an abnormal state (hereinafter, "abnormal battery") and a battery diagnosed as a normal state (hereinafter, "normal battery"). That is, the control unit 120 may electrically isolate the abnormal battery in which a micro-internal short circuit occurs from the normal battery. For example, the control unit 120 may control a switching element, etc. corresponding to the abnormal battery to a turn-off state. As another example, the control unit 120 may blow out a fuse corresponding to the abnormal battery.

In another embodiment, the control unit 120 may output information about the abnormal battery to the outside. For example, the control unit 120 may output information about the abnormal battery to an external display device or alarm device. Accordingly, a user or the like may quickly access information about the abnormal battery.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the voltage measuring unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack 10. That is, the battery pack 10 according to the present disclosure may include the above-described apparatus 100 for diagnosing a battery and at least one battery cell. Additionally, the battery pack 10 may further include electrical components (relays, fuses, etc.) and a case.

FIG. 5 is a diagram showing an exemplary configuration of a battery pack 10 according to another embodiment of the present disclosure. Preferably, the battery pack 10 may include the apparatus 100 for diagnosing a battery.

The battery pack 10 may include a first battery Ba, a second battery Bb, a third battery Bc, and a fourth battery Bd. For example, in the embodiment of FIG. 5, the first battery Ba, the second battery Bb, the third battery Bc, and the fourth battery Bd may be connected in series. However, it should be noted that the number of batteries included in the battery pack 10 and the connection relationship (series and/or parallel) of the batteries are not limited by the embodiment of FIG. 5.

The positive electrode terminal of the first battery Ba may be connected to the positive electrode terminal P+ of the battery pack 10, and the negative electrode terminal of the fourth battery Bd may be connected to the negative electrode terminal P- of the battery pack 10.

The voltage measuring unit 110 may be connected to the first sensing line SL1, the second sensing line SL2, the third sensing line SL3, the fourth sensing line SL4, and the fifth sensing line SL5.

Specifically, the voltage measuring unit 110 may be connected to the positive electrode terminal of the first battery Ba through the first sensing line SL1, and may be connected to the negative electrode terminal of the first battery Ba through the second sensing line SL2. The voltage measuring unit 110 may measure the voltage of the first battery Ba based on the voltage measured from each of the first sensing line SL1 and the second sensing line SL2.

Similarly, the voltage measuring unit 110 may measure the voltage of the second battery Bb through the second sensing line SL2 and the third sensing line SL3, measure the voltage of the third battery Bc through the third sensing line SL3 and the fourth sensing line SL4, and measure the voltage of the fourth battery Bd through the fourth sensing line SL4 and the fifth sensing line SL5.

An external device may be connected to the positive electrode terminal P+ and the negative electrode terminal P- of the battery pack 10. For example, the external device may be a motor of an electric vehicle that receives power from the battery pack 10. As another example, the external device may be a charging device for charging the battery pack 10.

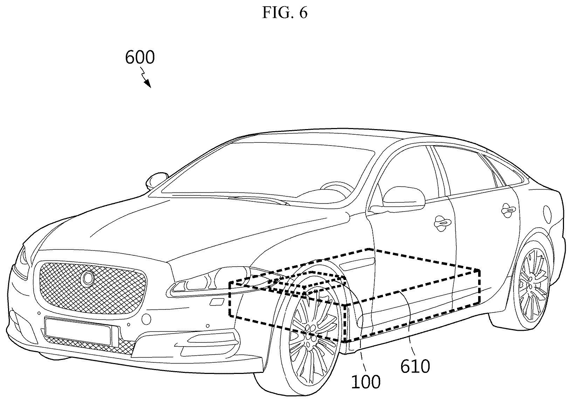

FIG. 6 is a diagram schematically showing a vehicle 600 according to still another embodiment of the present disclosure.

Referring to FIG. 6, the battery pack 610 according to an embodiment of the present disclosure may be included in a vehicle 600 such as an electric vehicle (EV) or a hybrid vehicle (HV). Additionally, the battery pack 610 may drive the vehicle 600 by supplying power to the motor through an inverter provided in the vehicle 600.

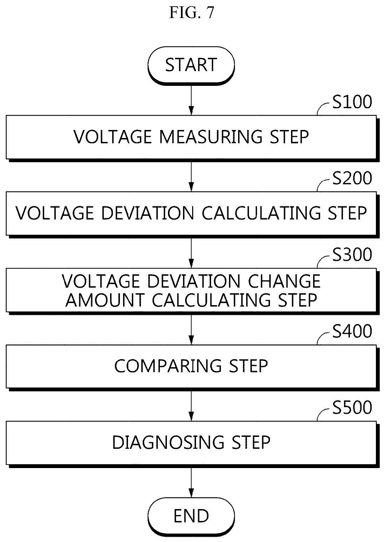

FIG. 7 is a diagram schematically showing a method for diagnosing a battery according to still another embodiment of the present disclosure.

Preferably, each step of the method for diagnosing a battery may be performed by the apparatus 100 for diagnosing a battery. Hereinafter, for convenience of explanation, the content overlapping with the previously described content will be briefly described or omitted.

The voltage measuring step (S100) is a step of measuring the voltages of a plurality of batteries, and may be performed by the voltage measuring unit 110.

For example, the voltage measuring unit 110 may measure the voltage of each of a plurality of batteries.

In the embodiment of FIG. 2, the voltage measuring unit 110 may measure the voltages of the first battery Ba, the second battery Bb, the third battery Bc, and the fourth battery Bd as Va, Vb, Vc, and Vd.

The voltage deviation calculating step (S200) is a step for calculating the voltage deviation of a plurality of batteries, and may be performed by the control unit 120.

For example, the control unit 120 may calculate the average voltage of the plurality of batteries. Then, the control unit 120 may calculate the voltage deviation of each of the plurality of batteries by calculating the difference between the calculated average voltage and the voltage of each of the plurality of batteries.

In the embodiment of FIG. 2, the control unit 120 may calculate the average voltage of the first battery Ba, the second battery Bb, the third battery Bc, and the fourth battery Bd as Vavg. The control unit 120 may calculate the difference between the voltage of the first battery Ba, the second battery Bb, the third battery Bc, and the fourth battery Bd and the average voltage to calculate the voltage deviation of the first battery Ba, the second battery Bb, the third battery Bc, and the fourth battery Bd as dVa, dVb, dVc, and dVd.

The voltage deviation change amount calculating step (S300) is a step of calculating the voltage deviation change amount of each of the plurality of batteries based on the voltage deviation calculated in the voltage deviation calculating step (S200), and may be performed by the control unit 120.

In the embodiment of FIG. 3, the control unit 120 may calculate the second voltage deviation change amount as △dV2 according to the formula of "dV2 - dV1". The control unit 120 may calculate the third voltage deviation change amount as △dV3 according to the formula of "dV3 - dV2". The control unit 120 may calculate the fourth voltage deviation change amount as △dV4 according to the formula of "dV4 - dV3".

In another embodiment, the control unit 120 may calculate the voltage deviation change amount for the unit time point by dividing the calculated difference in voltage deviation by the difference in time point. For example, in the embodiment of FIG. 3, the control unit 120 may calculate the second voltage deviation change amount for the unit time point by calculating the equation "second voltage deviation change amount (△dV2) ÷ difference of time point (D2 - D1)". The control unit 120 may calculate the third voltage deviation change amount for the unit time point by calculating the equation "third voltage deviation change amount (△dV3) ÷ difference of time point (D3 - D2)". The control unit 120 may calculate the fourth voltage deviation change amount for the unit time point by calculating the equation "fourth voltage deviation change amount (△dV4) ÷ difference of time point (D4 - D3)".

The comparing step (S400) is a step of comparing the voltage deviation change amount of each of the plurality of batteries with a preset reference change amount, and may be performed by the control unit 120.

For example, in the embodiment of FIG. 3, the control unit 120 may compare each of the second voltage deviation change amount (△dV2), the third voltage deviation change amount (△dV3), and the fourth voltage deviation change amount (△dV4) with a reference change amount.

The diagnosing step (S500) is a step of diagnosing the state of each of the plurality of batteries according to the comparison result of the comparing step (S400), and may be performed by the control unit 120.

The control unit 120 may be configured to diagnose the state of the battery in which the voltage deviation change amount is greater than or equal to the reference change amount as an abnormal state. Conversely, the control unit 120 may be configured to diagnose the state of the battery in which the voltage deviation change amount is less than the reference change amount as a normal state.

For example, in the embodiment of FIG. 4, since the second voltage deviation change amount (△dV2) and the third voltage deviation change amount (△dV3) are smaller than the reference change amount (TH), the control unit 120 may diagnose the state of the battery as a normal state at the D2 time point and the D3 time point. Since the fourth voltage deviation change amount (△dV4) is larger than the reference change amount (TH), the control unit 120 may diagnose the state of the battery as an abnormal state at the D4 time point.

As another example, the control unit 120 may be configured to calculate the number of times the voltage deviation change amount is greater than or equal to the reference change amount, and to diagnose the state of the battery when the calculated number of times reaches a preset reference number as an abnormal state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
100: apparatus for diagnosing a battery
110: voltage measuring unit
120: control unit
130: storage unit
600: vehicle
610: battery pack

## Claims

1. An apparatus for diagnosing a battery, comprising:
a voltage measuring unit configured to measure voltages of a plurality of batteries; and
a control unit configured to calculate a voltage deviation of the plurality of batteries according to the measured plurality of voltages, calculate a voltage deviation change amount of each of the plurality of batteries based on the calculated voltage deviation, compare the voltage deviation change amount of each of the plurality of batteries with a preset reference change amount, and diagnose a state of each of the plurality of batteries according to the comparison result.

2. The apparatus for diagnosing a battery according to claim 1,
wherein the control unit is configured to calculate the voltage deviation change amount of each of the plurality of batteries based on a difference between the voltage deviation calculated at a current time point and a previous voltage deviation calculated at a previous time point.

3. The apparatus for diagnosing a battery according to claim 2,
wherein the control unit is configured to calculate the voltage deviation change amount by normalizing the difference between the voltage deviation and the previous voltage deviation with respect to a difference between the current time point and the previous time point.

4. The apparatus for diagnosing a battery according to claim 3,
wherein the control unit is configured to calculate a difference in voltage deviation by calculating the difference between the voltage deviation and the previous voltage deviation, calculate a difference in time point by calculating the difference between the current time point and the previous time point, and calculate the voltage deviation change amount for a unit time point by dividing the difference in voltage deviation by the difference in time point.

5. The apparatus for diagnosing a battery according to claim 1,
wherein the control unit is configured to diagnose a state of a battery in which the voltage deviation change amount is greater than or equal to the reference change amount as an abnormal state, and
wherein the control unit is configured to diagnose a state of a battery in which the voltage deviation change amount is less than the reference change amount as a normal state.

6. The apparatus for diagnosing a battery according to claim 5,
wherein the control unit is configured to calculate the number of times the voltage deviation change amount is greater than or equal to the reference change amount and to diagnose a state of a battery in which the calculated number reaches a preset reference number as an abnormal state.

7. The apparatus for diagnosing a battery according to claim 5,
wherein the control unit is configured to diagnose that an internal micro short circuit occurs in the battery diagnosed as being in the abnormal state.

8. A battery pack, comprising the apparatus for diagnosing a battery according to any one of claims 1 to 7.

9. A vehicle, comprising the apparatus for diagnosing a battery according to any one of claims 1 to 7.

10. A method for diagnosing a battery, comprising:
a voltage measuring step of measuring voltages of a plurality of batteries;
a voltage deviation calculating step of calculating a voltage deviation of the plurality of batteries according to the plurality of voltages measured in the voltage measuring step;
a voltage deviation change amount calculating step of calculating a voltage deviation change amount of each of the plurality of batteries based on the voltage deviation calculated in the voltage deviation calculating step;
a comparing step of comparing the voltage deviation change amount of each of the plurality of batteries with a preset reference change amount; and
a diagnosing step of diagnosing a state of each of the plurality of batteries according to the comparison result of the comparing step.
